# EUROPEAN PATENT APPLICATION

(11) **EP 4 745 601 A1**
(43) Date of publication of application: **20.05.2026**
(21) Application number: 25216334.0
(22) Date of filing: 17.11.2025
(51) Int. Cl.: G01R 31/389

(54) **BATTERY MONITORING CIRCUITS CAPABLE OF GENERATING DATA ASSOCIATED WITH ELECTROCHEMICAL IMPEDANCE SPECTROSCOPY**

(30) Priority: 19.11.2024 US 202463722207 P; 07.10.2025 US 202519351758
(71) Applicant: O2Micro, Inc., Santa Clara, CA 95054 (US)
(72) Inventor: Li, Guoxing, Sunnyvale, 94089 (US)
(74) Representative: Lippert Stachow Patentanwälte Rechtsanwälte

(57) **Abstract**

In a battery monitoring circuit, a current path provides a stimulus current to flow through a battery in multiple time windows including a first time window and second time window. Stimulus circuitry generates a signal, including information for a waveform, to control the current path, thereby changing the stimulus current, and sets a stimulus frequency of the waveform to a first value in the first time window, and to a second value in the second time window. In each time window, the sampling circuitry performs operations including: measuring a voltage of the battery at a sampling frequency, higher than the stimulus frequency, to obtain voltage values; measuring a controllable current (including the stimulus current) synchronously with the measuring of the voltage to obtain current values; and generating EIS data based on voltage and current values. The sampling circuitry provides the EIS data to a controller to perform an EIS analysis.

## Description

### RELATED APPLICATION

This application claims priority to the U.S. Provisional Application with Serial No. 63/722,207, filed on November 19, 2024, which is hereby incorporated by reference in its entirety.

### BACKGROUND

Electrochemical impedance spectroscopy (EIS) is an electrochemical technique that can be applied to monitor a battery's state of health (SOH) and to estimate a battery's state of charge (SOC). In this technique, a small-amplitude alternating-current (AC) signal, such as a voltage or a current signal, is applied to the battery, and a corresponding current or voltage response of the battery is measured. The measured response can be used to determine impedance values of the battery at different frequencies. By applying AC signals of multiple different frequencies to the battery, multiple impedance values (including real components, imaginary components, impedance magnitudes, and/or phase angles) of the battery can be obtained. These impedance values can be represented by one or more EIS plots, such as a Nyquist plot (real part vs. imaginary part), a Bode magnitude plot (impedance magnitude vs. frequency), and/or a Bode phase plot (phase angle vs. frequency). For a battery in a healthy state, such plots exhibit patterns characteristic of the battery chemistry. Deviations from such patterns can indicate changes in SOH, and correlations between impedance features and charge storage characteristics can further provide estimates of SOC. Accordingly, practical implementations of EIS for battery monitoring can be useful for managing both SOH and SOC.

### SUMMARY

Embodiments according to the present invention provide circuits, systems, and methods for monitoring batteries based on the electrochemical impedance spectroscopy (EIS) technique.

In an embodiment, a battery monitoring circuit includes a current path, stimulus circuitry, and sampling circuitry. The current path provides a stimulus current that flows from a positive terminal of a battery, through the current path, and to a negative terminal of the battery in multiple time windows. The time windows include a first time window and a second time window. The stimulus circuitry generates a stimulus signal, including information for a waveform, to control the current path, thereby changing the stimulus current; sets a stimulus frequency of the waveform to a first frequency value in the first time window; and sets the stimulus frequency to a second frequency value in the second time window. The second frequency value is different from the first frequency value. The sampling circuitry performs a set of operations in each time window of the multiple time windows. The operations can include: measuring a voltage of the battery at a sampling frequency, higher than the stimulus frequency, to obtain a set of voltage values; measuring a controllable current (including the stimulus current) synchronously with the measuring of the voltage to obtain a set of current values; and generating EIS data based on the voltage values and the current values. The sampling circuitry provides the EIS data to a controller to perform an EIS analysis.

### BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:
FIG. 1 illustrates a block diagram of an example of a battery monitoring system, in an embodiment of the present invention.
FIG. 2 illustrates a block diagram of an example of a battery monitoring system, in an embodiment of the present invention.
FIG. 3 illustrates a block diagram of an example of a battery monitoring system, in an embodiment of the present invention.
FIG. 4 illustrates a block diagram of an example of a battery monitoring system, in an embodiment of the present invention.
FIG. 5 illustrates a block diagram of an example of a battery monitoring unit in a battery monitoring system, in an embodiment of the present invention.
FIG. 6 illustrates a block diagram of an example of a battery monitoring system, in an embodiment of the present invention.
FIG. 7 illustrates a diagram of a time sequence of an example of a process of collecting EIS data, in an embodiment of the present invention.
FIG. 8 illustrates a diagram of a time sequence of an example of a process of generating and controlling a stimulus current, in an embodiment of the present invention.
FIG. 9 illustrates a diagram of a time sequence of an example of a process of collecting EIS data, in another embodiment of the present invention.
FIG. 10 illustrates a flowchart of an example of a method for monitoring a battery, in an embodiment of the present invention.

### DETAILED DESCRIPTION

Reference will now be made in detail to the embodiments of the present invention. While the invention will be described in conjunction with these embodiments, it will be understood that they are not intended to limit the invention to these embodiments. On the contrary, the invention is intended to cover alternatives, modifications, and equivalents, which may be included within the spirit and scope of the invention as defined by the appended claims.

Furthermore, in the following detailed description of the present invention, numerous specific details are set forth in order to provide a thorough understanding of the present invention. However, it will be recognized by one of ordinary skill in the art that the present invention may be practiced without these specific details. In other instances, well known methods, procedures, components, and circuits have not been described in detail as not to unnecessarily obscure aspects of the present invention.

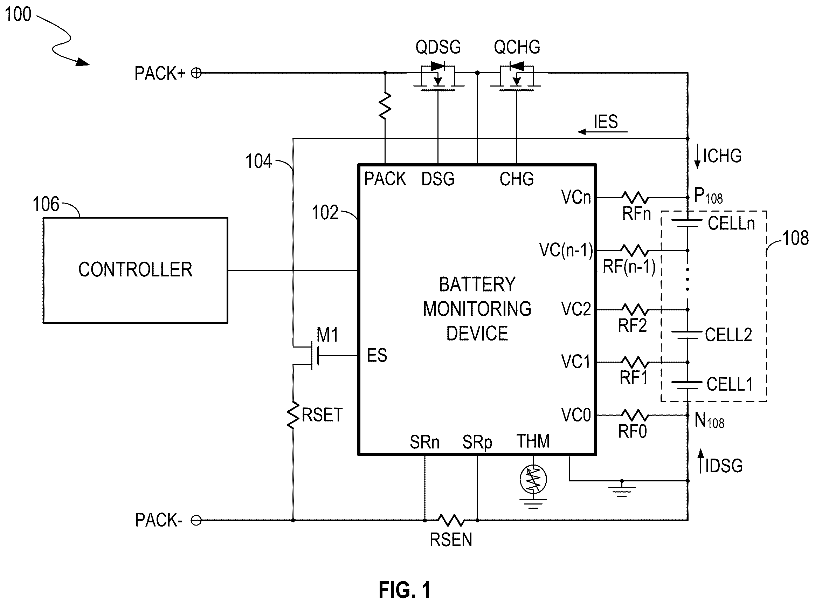

FIG. 1 illustrates a block diagram of an example of a battery monitoring system 100, in an embodiment of the present invention. The battery monitoring system 100 includes a battery monitoring device 102, a current path 104, and a controller 106 (e.g., a microcontroller unit; "MCU"). The battery monitoring device 102 can monitor statuses (e.g., including a voltage, a current, temperature, etc.) of a battery 108. The battery 108 can include one or more battery cells CELL1 to CELLn (where n is a natural number) coupled in series. The current path 104 can include a transistor M1 (e.g., a metal-oxide-semiconductor field-effect transistor (MOSFET), a bipolar junction transistor (BJT), or the like) and a current-setting resistor RSET. In some embodiments, the battery monitoring device 102 can cooperate with the current path 104 to generate EIS related data (hereinafter, EIS data) so that a controller or a control unit can perform EIS analysis for the battery 108 based on the EIS data. In some embodiments, the EIS analysis includes generating one or more EIS plots, such as a Nyquist plot (real part vs. imaginary part), a Bode magnitude plot (impedance magnitude vs. frequency), and/or a Bode phase plot (phase angle vs. frequency). Detailed explanations for these plots are available in the known art and so are not included herein. In an embodiment, the battery monitoring device 102 provides the EIS data to the controller 106 to perform the EIS analysis. In another embodiment, the battery monitoring device 102 includes a control unit that performs the EIS analysis. The battery monitoring device 102 can provide the analysis result, e.g., including information for the one or more EIS plots, to the controller 106. As a result, the battery monitoring system 100 can monitor statuses, e.g., including a state of health (SOH) and a state of charge (SOC), of the battery 108 based on the analysis result.

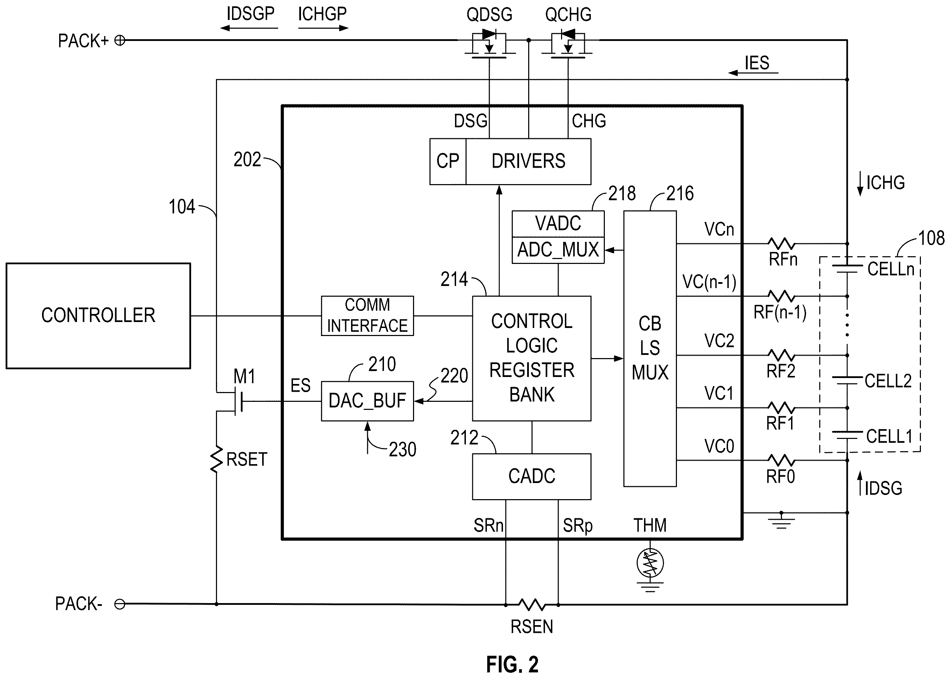

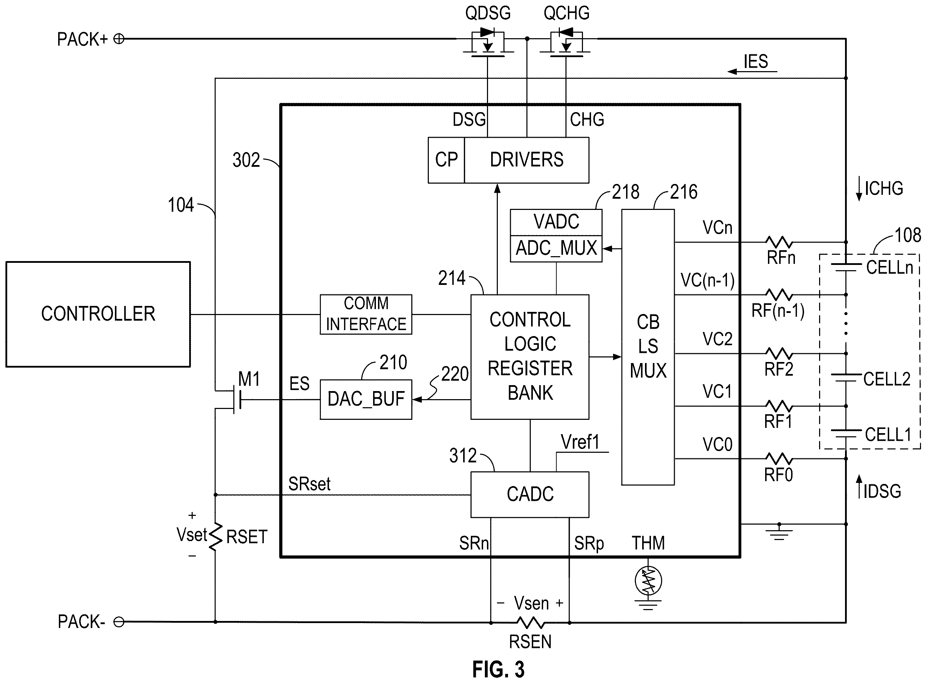

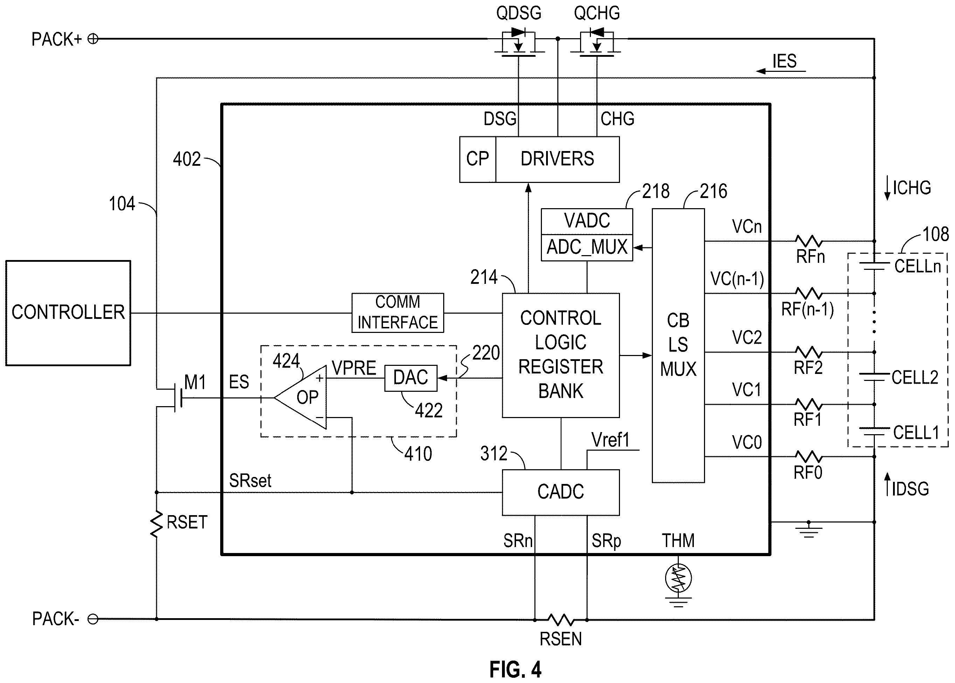

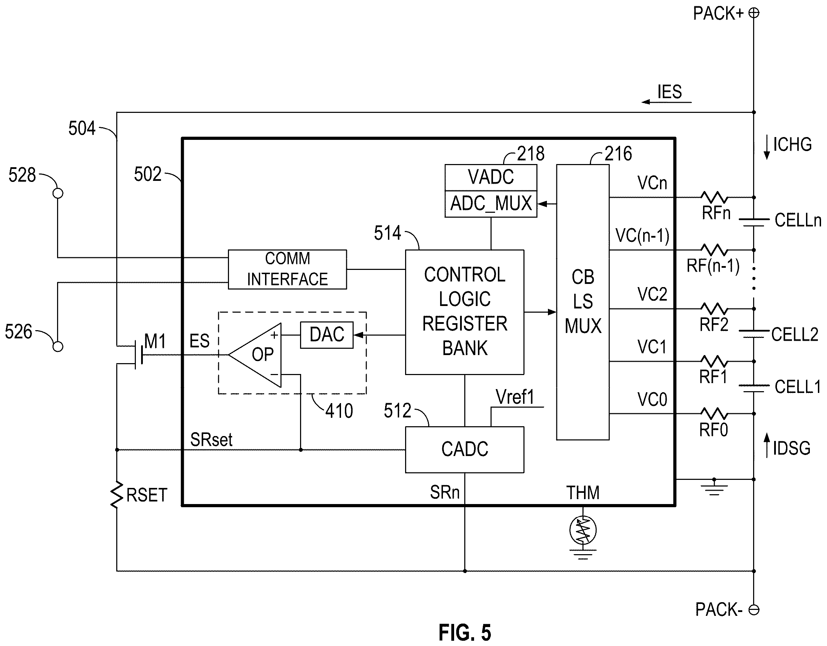

More specifically, as shown in FIG. 1, the battery monitoring device 102 includes voltage monitoring terminals VC0 to VCn and current sensing terminals SRn and SRp. The monitoring terminals VC0 to VCn are configured to monitor voltages of the battery 108, e.g., including respective cell voltages of the battery cells CELL1 to CELLn and/or a battery voltage across the battery 108 (e.g., a voltage between terminals P₁₀₈ and N₁₀₈ shown in FIG. 1). The sensing terminals SRn and SRp are configured to sense a battery current (e.g., a charging current ICHG or a discharging current IDSG) of the battery 108 by measuring a voltage across a sensing resistor RSEN coupled in series to the battery 108. The battery monitoring device 102 also includes a control terminal ES that controls the transistor M1 to control the current path 104. The current path 104 is coupled between the positive terminal P₁₀₈ of the battery 108 (e.g., the positive terminal of the top battery cell CELLn) and the negative terminal N₁₀₈ of the battery 108 (e.g., the negative terminal of the bottom battery cell CELLn). When the transistor M1 is turned on, a stimulus current IES can be generated to flow from the positive terminal P₁₀₈ of the battery 108 to the negative terminal N₁₀₈ of the battery 108 through the current path 104. The battery monitoring device 102 also includes stimulus-and-sampling circuitry configured to operate in a mode of a regular mode and a stimulus mode. The stimulus-and-sampling circuitry may include the function blocks 210, 212, 214, 216 and 218 shown in FIG. 2, the function blocks 210, 312, 214, 216 and 218 shown in FIG. 3, the function blocks 410, 312, 214, 216 and 218 shown in FIG. 4, or the function blocks 410, 512, 514, 216 and 218 shown in FIG. 5.

In some embodiments, in the regular mode, the stimulus-and-sampling circuitry turns off the transistor M1 and the current path 104. In other words, no stimulus current IES is generated in the regular mode. The stimulus-and-sampling circuitry can perform regular monitoring of the battery 108 including, but not limited to, sampling the battery's current, temperature, and cell voltages at a regular sampling frequency that can be relatively low, e.g., in the range of tens to hundreds of Hertz (Hz). In the stimulus mode, the stimulus-and-sampling circuitry enters an EIS-data-collecting time window.

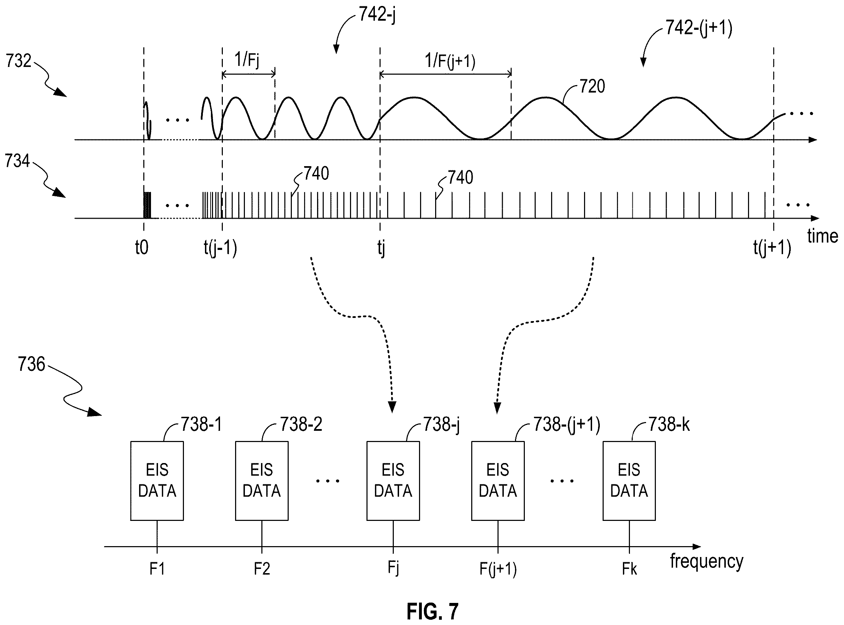

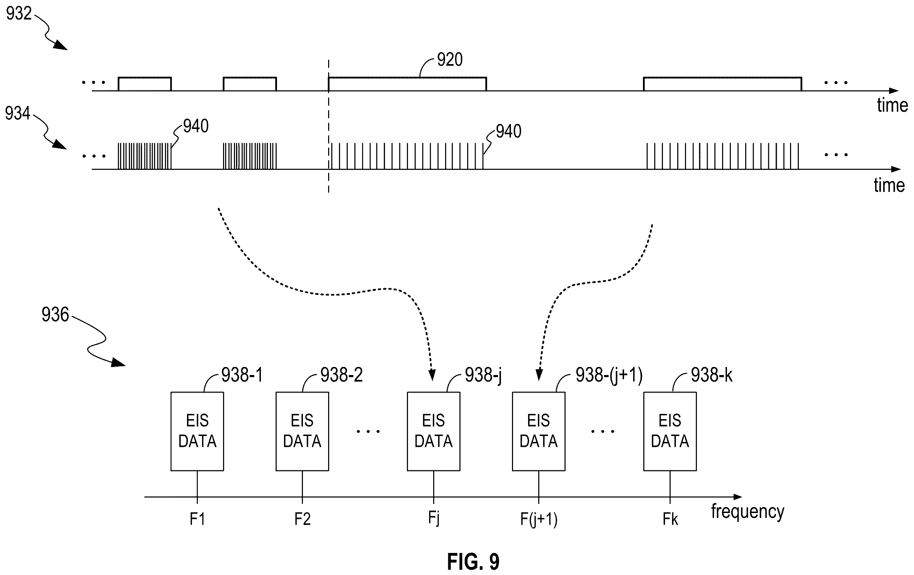

In the EIS-data-collecting time window, the stimulus-and-sampling circuitry can generate a stimulus signal (e.g., a signal 220 shown in FIG. 2) having information for a waveform. The waveform has a stimulus frequency F_{EIS} that is programable and may be ranged from 0.1Hz to 10kHz, for example. In some embodiments, the waveform may include a sine wave, e.g., similar to the waveform 720 shown in FIG. 7. In some other embodiments, the waveform may include a square wave, e.g., similar to the waveform 920 shown in FIG. 9. The stimulus-and-sampling circuitry can also control the transistor M1 based on the stimulus signal (e.g., 220) thereby changing the stimulus current IES. The stimulus-and-sampling circuitry can also measure a battery voltage VB of the battery 108 (e.g., a voltage of a cell of the battery cells CELL1 to CELLn or a voltage across the battery cells CELL1 to CELLn) at a sampling frequency F_{SP} to obtain a set of voltage values, where the sampling frequency F_{SP} is higher than the stimulus frequency F_{EIS}. In other words, the stimulus-and-sampling circuitry can sample the battery voltage VB multiple times to obtain a set of values of the battery voltage VB, and the sampling frequency is set to an F_{SP} that is higher than the stimulus frequency F_{EIS}. The stimulus-and-sampling circuitry can also measure a controllable current IB, including the stimulus current IES, synchronously with the measuring of the battery voltage VB to obtain a set of current values. In some embodiments, the controllable current IB is a battery current, e.g., a charging current ICHG or a discharging current IDSG, of the battery 108. That is, the stimulus-and-sampling circuitry can synchronously measure the battery current and battery voltage of the battery 108. Because the stimulus current IES flows through the battery 108, the battery current includes the stimulus current IES, and a variation in the battery current can reflect a variation in the stimulus current IES. In some other embodiments, the controllable current IB is the stimulus current IES. That is, the stimulus-and-sampling circuitry can synchronously measure the stimulus current IES and the battery voltage VB. As used herein, "synchronously" means that the measuring of the battery voltage VB and the measuring of the controllable current IB are performed at the same time or approximately the same time (e.g., concurrently or contemporaneously), or are considered to be performed at the same time. As used herein, "approximately the same time" means that a time difference may exist between the measuring of the battery voltage VB and the measuring of the controllable current IB due to nonideality of circuit components, and the time difference is relatively small and can be ignored. As used herein, "considered to be performed at the same time" means that the cell voltages of the battery cells CELL1 to CELLn and the controllable current IB are measured in a special manner to produce calculated values of the cell voltages and a value of the controllable current IB. The calculated values of the cell voltages and the value of the controllable current IB can be considered to be sensed at the same time point. Examples of the special manner can be found in U.S. Patent Application No. 18/527,055, filed on December 1, 2023, hereby incorporated in the present application by reference in its entirety for all purposes. The stimulus-and-sampling circuitry can also generate EIS data based on the set of voltage values of the battery voltage VB and the set of current values of the controllable current IB. The EIS data can include information for the set of voltage values and the set of current values. In some embodiments, the EIS data can further include information for the frequency value of the stimulus frequency F_{EIS}.

In some embodiments, the stimulus-and-sampling circuitry can enter multiple EIS-data-collecting time windows sequentially. The stimulus-and-sampling circuitry can repeat the abovementioned operations in each time window of the multiple EIS-data-collecting time windows. The stimulus frequencies F_{EIS} of the stimulus signal (e.g., 220 in FIG. 2) in the multiple time windows can be different from each other. For example, the stimulus-and-sampling circuitry can set the stimulus frequency F_{EIS} to a first frequency value in a first time window of the multiple EIS-data-collecting time windows, and set the stimulus frequency F_{EIS} to a second frequency value, different from the first frequency value, in a second time window of the multiple EIS-data-collecting time windows. Accordingly, the stimulus-and-sampling circuitry can generate multiple sets of EIS data, each set of EIS data corresponding to the stimulus frequency F_{EIS} in a respective time window of the multiple EIS-data-collecting time windows. The stimulus-and-sampling circuitry can provide the multiple sets of EIS data to a controller, e.g., the controller 106 or a control unit in the battery monitoring device 102, to perform the EIS analysis.

As mentioned above, the current path 104 is coupled between the positive terminal P₁₀₈ of the battery 108 and the negative terminal N₁₀₈ of the battery 108. Therefore, the stimulus current IES through the current path 104 can reduce a charging current ICHG of the battery 108 if the battery 108 is in a charging mode, and increase a discharging current IDSG of the battery 108 if the battery 108 is in a discharging mode. Changes in the stimulus current IES can result in corresponding changes in the battery current and cell voltages of the battery cells CELL1 to CELLn. The EIS data generated by the battery monitoring device 102 can reflect the changes in the battery current and cell voltages. As a result, the EIS data can be used for the EIS analysis.

Thus, in an embodiment of the present invention, a method for generating EIS data includes using the battery monitoring device 102 to control the current path 104 so that a stimulus current IES is generated to flow through the battery 108 and the current path 104. In response to the generation of the stimulus current IES, the battery monitoring device 102 can measure the battery cells' voltages and measure the stimulus current IES, thereby generating the EIS data.

Another possible method for generating EIS data may include generating EIS stimulus currents through the input filter resistors RF0 to RFn sequentially and measuring cell voltages of the cells CELL1 to CELLn in response to the generation of the EIS stimulus currents. For example, a current generator circuit may be used to generate an EIS stimulus current to flow through the battery cell CELL1 and the resistors RF1 and RF0. Similarly, an EIS stimulus current may be generated to flow through the battery cell Cell2 and the resistors RF2 and RF1; and so on. In high power battery cell/pack application, internal impedances of the battery cells are relatively small, e.g., down to the milliohm level. Thus, in this possible method, relatively large EIS stimulus currents are used to develop measurable voltage drops across the internal impedances. For example, a current of 1A flowing through an impedance of 1 milliohm produces a voltage drop of only 1mV. In order to get more reliable analog-to-digital conversion results, larger EIS stimulus currents are required. In addition, resistances of the input filter resistors RF0 to RFn are required to be higher than a specific level to satisfy a basic requirement of the battery monitoring device. As a result, applying relatively large EIS stimulus currents, e.g., 1A, 2A, etc., on the resistors RF0 to RFn can result in relatively large voltage drops across the resistors RF0 to RFn, which usually is not allowed because it reduces system reliability and may increase overall risk to the battery pack. In addition, larger voltage drops across the resistors RF0 to RFn require the battery monitoring device to tolerate higher board level electrostatic discharge (ESD), which can increase the cost. Additionally, in this possible method, the current generator circuit needs to have multiple output terminals to generate multiple stimulus currents for the battery cells Cell1 to Celln respectively, which further increases the cost. Advantageously, in an embodiment of the present invention, the battery monitoring device 102 controls the current path 104 to generate a stimulus current IES to flow through the battery cells CELL0 to CELLn. The stimulus current IES does not impact the input filter resistors RF0 to RFn and therefore does not produce the abovementioned problems in the possible method just described. Moreover, because the resistance of the current-setting resistor RSET can be selected in a relatively wide range, the stimulus current IES can also be adjusted in a relatively wide range.

FIG. 2 illustrates a block diagram of an example of a battery monitoring system that includes a battery monitoring device 202, in an embodiment of the present invention. FIG. 2 is described in combination with FIG. 1. The battery monitoring device 202 can be an embodiment of the battery monitoring device 102 in FIG. 1. As shown in FIG. 2, the battery monitoring device 202 includes function blocks 210, 212, 214, 216, and 218. The function block 210 can include a combined circuit of a digital-to-analog converter (DAC) and a buffer (BUF), and may be referred to as "a stimulus-current-control circuit 210." The function block 212 can include an analog-to-digital converter (ADC) for measuring a current, and may be referred to as "a current-measurement circuit 212." The function block 214 can include a combined circuit of a control logic circuit and a register bank, and may be referred to as "a control-and-storage circuit 214." The function block 216 can include a combined circuit of a circuit breaker (CB), a level shifter (LS), and a multiplexer (MUX). The function block 218 can include a combined circuit of an ADC for measuring a voltage and a multiplexer (MUX). The function blocks 216 and 218 can form a circuit referred to as "a voltage-measurement circuit 216-218." In some embodiments, circuitry including the circuits 210 and 214 may be referred to as "stimulus circuitry," and circuitry including the circuits 212, 214, 216 and 218 may be referred to as "sampling circuitry."

In the stimulus circuitry, the control-and-storage circuit 214 can generate a stimulus signal 220. The stimulus signal 220 can be a digital signal including information for a waveform, e.g., similar to the waveform discussed above in relation to FIG. 1. The stimulus signal 220 can be fed into the DAC in the stimulus-current-control circuit 210 and converted to an analog control signal, e.g., a voltage signal, having the waveform indicated by the stimulus signal 220. In the example of FIG. 2, the analog control signal is generated at the control terminal ES to control the transistor M1 in the current path 104, thereby changing the stimulus current IES. Thus, the stimulus current IES carries the information for the waveform indicated by the stimulus signal 220. The control-and-storage circuit 214 can also set/control the stimulus frequency of the waveform to have different frequency values.

In the sampling circuitry, the voltage-measurement circuit 216-218 can perform the measuring of the abovementioned battery voltage VB, and the current-measurement circuit 212 can perform the measuring of the abovementioned controllable current IB. The control-and-storage circuit 214 can collect and store information for the battery voltage VB and battery current IB. In an embodiment, EIS data generated by the control-and-storage circuit 214 may include the information for the battery voltage VB and battery current IB. In another embodiment, the cell voltages of the battery cells CELL1 to CELLn may be measured in a predetermined sequence, and the control-and-storage circuit may perform calculations on the measured cell voltages to obtain calculated cell voltages that are considered to be the cell voltages measured/sensed at a same time point. The controllable current IB can also be measured at that same time point. EIS data generated by the control-and-storage circuit 214 can include data for the calculated cell voltages and the data for the controllable current IB. The control-and-storage circuit 214 can provide the EIS data to a controller or a control unit to perform the EIS analysis.

In the example of FIG. 2, the controllable current IB measured by the current-measurement circuit 212 is a battery current such as a charging current ICHG or a discharging current ICHG of the battery 108. More specifically, the battery current flows through a sensing resistor RSEN coupled in series to the battery 108. The current-measurement circuit 212 (e.g., including an ADC) can measure a voltage across the sensing resistor RSEN by converting the voltage to digital information. The digital information indicates a value of the battery current.

In some embodiments, the battery 108 and the battery monitoring device 202 are included in a battery pack that has a positive pack terminal PACK+ and a negative pack terminal PACK-. When the battery 108 is in a charging mode, a charging current ICHGP flows from the positive pack terminal PACK+ to the negative pack terminal PACK- through the battery 108. When the battery 108 is in a discharging mode, a discharging current IDSGP flows from the negative pack terminal PACK- to the positive pack terminal PACK+ through the battery 108. In some embodiments, the battery 108 can be considered to be in a stable state in a predetermined time window, e.g., an abovementioned EIS-data-collecting time window, if the charging current ICHGP or the discharging current IDSGP is set to be constant in the predetermined time window. As used herein, a current "is set to be constant" means that the current is set or programmed to be constant but, in reality, variation(s) may exist in the current due to nonideality of circuit components and any variation is relatively small and can be ignored. The battery 108 can also be considered to be in the stable state if neither the charging current ICHGP nor the discharging current IDSGP is generated in the predetermined time window. When the battery 108 is in the stable state, the current-measurement circuit 212 can sample the battery current, e.g., ICHG or ICHG, at an abovementioned sampling frequency F_{SP}. In an embodiment, the current-measurement circuit 212 samples the battery current at a first time point to obtain a first current value, and samples the battery current at a second time point, following the first time point, to obtain a second current value. A difference between the first and second current values can reflect a response of the battery current of the battery 108 to the stimulus current IES, which may be used for the EIS analysis. In another embodiment, the current-measurement circuit 210 may be enabled, e.g., by a control signal 230, at the sampling frequency F_{SP}, and therefore the stimulus current IES is enabled at the sampling frequency F_{SP}. The current-measurement circuit 212 can measure the battery current to obtain a third current value when the stimulus current IES is enabled, and measure the battery current to obtain a fourth current value immediately after the stimulus current IES is disabled (or immediately before the stimulus current IES is enabled). A difference between the third and fourth current values can indicate a value of the stimulus current IES, which can be used for the EIS analysis.

However, in some practical situations, the battery 108 may not be in the stable state. Additionally, power consumption of the battery monitoring device 202 may affect the measured battery current, which can reduce the accuracy of the EIS data. Therefore, a battery monitoring device that measures the stimulus current IES without involving the battery current, e.g., ICHG or ICHG, can be beneficial.

FIG. 3 illustrates a block diagram of an example of a battery monitoring system that includes a battery monitoring device 302, in another embodiment of the present invention. FIG. 3 is described in combination with FIG. 1 and FIG. 2. The battery monitoring device 302 can be an embodiment of the battery monitoring device 102 in FIG. 1. As shown in FIG. 3, the battery monitoring device 302 is similar to the battery monitoring device 202 in FIG. 2 except that the battery monitoring device 302 further includes a sensing terminal SRset coupled to the current-setting resistor RSET, and the current-measurement circuit 312 of the battery monitoring device 302 can measure a sensing voltage Vsen across the sensing resistor RSEN and measure a setting voltage Vset across the current-setting resistor RSET. In other words, the current-measurement circuit 312 can measure a battery current, e.g., ICHG or ICHG, of the battery 108 through the sensing resistor RSEN, and can also measure the stimulus current IES through the current-setting resistor RSET. In some embodiments, the current-measurement circuit 312 uses one ADC to measure the battery current and the stimulus current IES. In such embodiments, the current-measurement circuit 312 may further include a selector, e.g., a multiplexer, configured to select the sensing voltage Vsen or the setting voltage Vset to be output to the ADC. In some other embodiments, the current-measurement circuit 312 uses two ADCs to measure the battery current and the stimulus current IES respectively.

In an abovementioned embodiment in which the current-measurement circuit 312 uses one ADC to measure the battery current and the stimulus current IES, a reference voltage Vrefl that controls an input range of the ADC may be set to different voltage levels in the abovementioned regular mode and stimulus mode. In an embodiment, the ADC includes a unipolar ADC, and the input range of the ADC can 0 to Vrefl. In another embodiment, the ADC includes a bipolar ADC, and the input range of the ADC can be -Vrefl to Vrefl. In the abovementioned regular mode, the current path 104 is turned off. The ADC in the current-measurement circuit 312 is set to measure the battery current of the battery 108 by measuring a sensing voltage Vsen across the sensing resistor RSEN. In some embodiments, the resistance of the sensing resistor RSEN is relatively small, e.g., less than one (1) milliohm. Therefore, the sensing voltage Vsen across the sensing resistor RSEN is relatively small. The reference voltage Vrefl can be set, e.g., using the control-and-storage circuit 214, to be a first value such that the input range of the ADC is relatively small, e.g., less than 100mV. In an embodiment, reducing an input range of an ADC can reduce the least significant bit (LSB) of the ADC, thereby increasing the accuracy of the analog-to-digital conversion. Thus, if the ADC is used to measure a smaller voltage, the input range of the ADC will be smaller. In the abovementioned stimulus mode, the battery monitoring device 302 enters an EIS-data-collecting time window. The ADC in the current-measurement circuit 312 is set to measure the stimulus current IES by measuring a setting voltage Vset across the current-setting resistor RSET. In an embodiment, the setting voltage Vset across the current-setting resistor RSET can be much larger than the sensing voltage Vsen across the sensing resistor RSEN. Consequently, the ADC input range used for measuring the sensing voltage Vsen in the regular mode may be too small to measure the setting voltage Vset. Therefore, when entering the stimulus mode, the reference voltage Vrefl can be set to a second value greater than the first value such that the setting voltage Vset is within the input range of the ADC. Because the reference voltage Vrefl is controllable, a maximum allowed limit of the setting voltage Vset across the current-setting resistor Rset is controllable. As a result, in an embodiment, the current-setting resistor Rset can be selected to have higher resistance, and the transistor M1 can be selected to have lower voltage tolerance, which can reduce the cost of the battery monitoring system.

Additionally, in the example of FIG. 3, the abovementioned controllable current IB is the stimulus current IES. More specifically, in the stimulus mode, the battery monitoring device 302 can measure a battery voltage VB of the battery 108 (e.g., a voltage of a cell of the battery cells CELL1 to CELLn, a voltage across the battery cells CELL1 to CELLn, or a voltage between the positive pack terminal PACK+ and the negative pack terminal PACK-) and the stimulus current IES. The measuring of the battery voltage VB and the measuring of the stimulus current IES can be performed synchronously.

In the examples of FIG. 2 and FIG. 3, the stimulus-current-control circuit 210 generates an analog control signal at the control terminal ES to control a gate voltage of the transistor M1, e.g., a MOSFET, according to the stimulus signal 220. Therefore, the stimulus current IES is controlled not only by the stimulus signal 220 but also by the drain-source on-resistance R_{DS(ON)} of the transistor M1 and the turn-on threshold V_{TH} of the transistor M1. In some embodiments, the drain-source on-resistance R_{DS(ON)} and turn-on threshold V_{TH} of the transistor M1 can vary, e.g., over temperature, which results in variation of the stimulus current IES through the transistor M1 - that is, the stimulus current IES may vary in a range but cannot be set to a predetermined value. Accordingly, another embodiment of the present invention is provided in FIG. 4, in which the stimulus current IES can be set to a predetermined value.

FIG. 4 illustrates a block diagram of an example of a battery monitoring system that includes a battery monitoring device 402, in an embodiment of the present invention. FIG. 4 is described in combination with FIG. 1, FIG. 2, and FIG. 3. The battery monitoring device 402 can be an embodiment of the battery monitoring device 102 in FIG. 1. As shown in FIG. 4, the battery monitoring device 402 is similar to the battery monitoring device 302 in FIG. 3 except that the stimulus-current-control circuit 410 in the battery monitoring device 402 can apply a voltage, determined by the stimulus signal 220, to the current-setting resistor RSET.

For example, the stimulus-current-control circuit 410 can include a digital-to-analog converter (DAC) 422 and an operational amplifier 424. The DAC 422 converts the digital stimulus signal 220 to a preset voltage VPRE. The operational amplifier 424 has a first input terminal, e.g., a positive input terminal, configured to receive the preset voltage VPRE, an output terminal configured to control the transistor M1, and a second input terminal, e.g., a negative input terminal, configured to apply the preset voltage VPRE to the current-setting resistor RSET. More specifically, the combined circuit of the operational amplifier 424, the transistor M1, and the current-setting resistor RSET form a control loop that enables the virtual-short feature of the operational amplifier 424 - that is, voltage levels at the positive and negative input terminals of the operational amplifier 424 are the same or substantially the same. Thus, the operational amplifier 424 can be considered to apply the preset voltage VPRE to the current-setting resistor RSET, thereby setting the stimulus current IES to a predetermined value given by: V_{PRE}/R_{SET}, where V_{PRE} represents the voltage level of the preset voltage VPRE, and R_{SET} represents the resistance of the current-setting resistor RSET. In this example, the operational amplifier 424 can be referred to as a voltage follower or a buffer.

In an embodiment, because the stimulus current IES can be set to a predetermined value, measuring the stimulus current IES by measuring a voltage across the current-setting resistor RSET may be unnecessary. For example, the battery monitoring device 402 can measure the stimulus current IES by obtaining a digital value of the stimulus signal 220. The battery monitoring device 402 may synchronously obtain a digital value of the stimulus signal 220 and measure the abovementioned battery voltage VB of the battery 108. In another embodiment, the battery monitoring device 402 can measure the stimulus current IES by measuring a voltage across the current-setting resistor RSET and determine whether an abnormal condition is present by comparing the measured stimulus current IES and the predetermined value. If the measured stimulus current IES is equal to or approximately equal to the predetermined value, then the battery monitoring device 402 can determine that the function blocks 214 and 410 operate properly. If a difference between the measured stimulus current IES and the predetermined value exceeds a predetermined reference value, then the battery monitoring device 402 can determine that an abnormal condition is present in the function blocks 214 and 410.

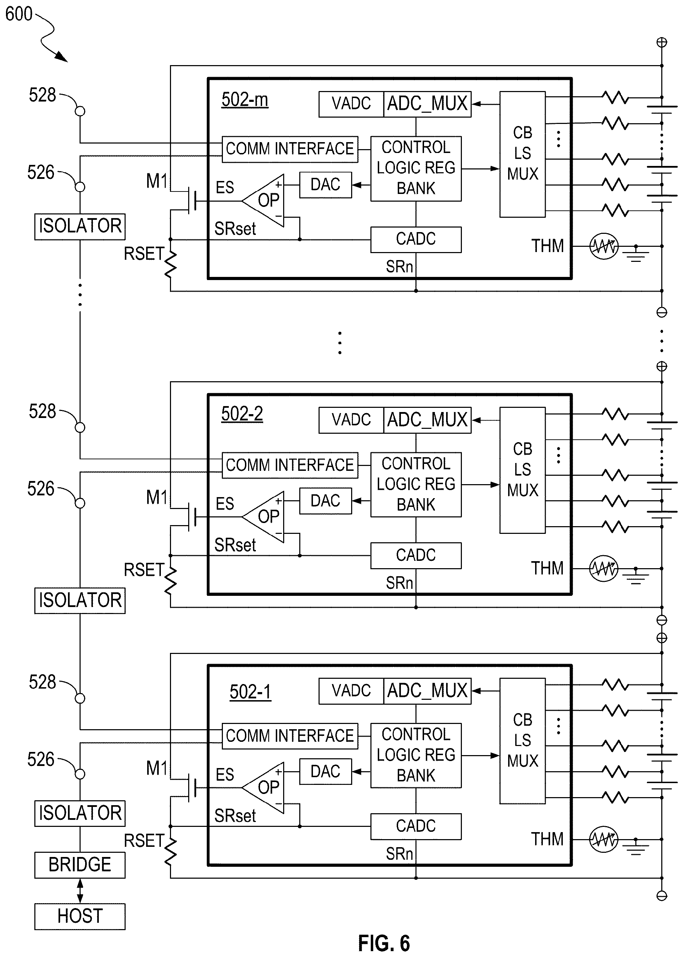

FIG. 5 illustrates a block diagram of an example of a battery monitoring system that includes a battery monitoring unit 502, in an embodiment of the present invention. FIG. 5 is described in combination with FIG. 1, FIG. 2, FIG. 3, and FIG. 4. In some embodiments, the battery monitoring unit 502 can be coupled to other similar or identical units in a daisy-chain (e.g., as shown in FIG. 6). The units can communicate with each other.

As shown in FIG. 5, the battery monitoring unit 502 includes circuits 410, 512, 514, 216, and 218. The circuits 216 and 218 in FIG. 5 can be the same as or similar to the circuits 216 and 218 in FIG. 2. The circuit 410 in FIG. 5 can be the same as or similar to the circuit 410 in FIG. 4. Similar to the circuit 312 in FIG. 3 and FIG. 4, the current-measurement circuit 512 in FIG. 5 can measure a stimulus current IES through a current path 504 coupled between the positive terminal of the top battery cell CELLn and the negative terminal of the bottom battery cell CELL1. Under the control of the control-and-storage circuit 514, the circuits 512, 216, and 218 can synchronously measure the stimulus current IES and a battery voltage VB of the battery cells CELL1 to CELLn (e.g., a cell voltage of a battery cell or a voltage across the battery cells CELL1 to CELLn). Additionally, the battery monitoring unit 502 can include communication terminals 526 and 528 configured to communicate with other similar or identical units in a daisy-chain. The battery monitoring unit 502 can generate EIS data based on the measured stimulus current IES and voltage VB and send the EIS data to a host or an MCU through the communication terminals 526 and 528.

FIG. 6 illustrates a block diagram of an example of a battery monitoring system 600, in an embodiment of the present invention. FIG. 6 is described in combination with FIG. 1, FIG. 2, FIG. 3, FIG. 4, and FIG. 5. As shown in FIG. 6, the battery monitoring system 600 includes battery monitoring units 502-1 to 502-m (where m is a natural number). Each of the battery monitoring units 502-1 to 502-m can be the same as or similar to the battery monitoring unit 502 in FIG. 5. The battery monitoring units 502-1 to 502-m are coupled to each other through their respective communication terminals 526 and 528, and therefore form a daisy chain. Each of the battery monitoring units 502-1 to 502-m can generate its respective EIS data and send the EIS data to a host or an MCU through the daisy chain. That is, in the example embodiment of FIG. 6, the EIS data of battery monitoring unit 502-m is sent to battery monitoring unit 502-(m-1), and so on until the data reaches battery monitoring unit 502-1, which sends the data to the host or MCU.

FIG. 7 illustrates a diagram of a time sequence of an example of a process of collecting EIS data, in an embodiment of the present invention. FIG. 7 is described in combination with FIG. 1, FIG. 2, FIG. 3, FIG. 4, FIG. 5, and FIG. 6. The diagram in FIG. 7 includes plots 732, 734 and 736. Plot 732 shows an example of a waveform 720 indicated by the abovementioned stimulus signal 220. In the example of FIG. 7, the waveform 720 is a sine wave. Plot 734 shows an example of a time sequence of sampling points 740 (e.g., time points) of the abovementioned battery voltage VB and controllable current IB. Plot 732 shows multiple EIS datasets 738-1 to 738-k (where k is a natural number) associated with respective frequency values F1 to Fk of the waveform 720.

More specifically, in plot 732, the reference characters 742-j and 742-(j+1) represent two time windows of multiple EIS-data-collecting time windows 742-1 to 742-k. The time window 742-j begins at time t(j-1) and ends at time tj. The time window 742-(j+1) begins at time tj and ends at time t(j+1). FIG. 7 shows only the reference characters 742-j and 742-(j+1) for simplicity. As shown in plot 732, the waveform 720 is controlled to have different frequency values in different time windows. For example, the frequency of the waveform 720 is set to be Fj in the time window 742-j, and set to be F(j+1) in the time window 742-(j+1). The frequency of the waveform 720 is determined or controlled by a stimulus signal 220 generated by stimulus circuitry (e.g., including the circuits 210 and 214 in FIG. 2 or FIG. 3, the circuits 410 and 214 in FIG. 4, or the circuits 410 and 514 in FIG. 5). The abovementioned stimulus current IES is generated according to the stimulus signal 220 and therefore carries the information for the waveform 720.

In plot 734, the reference character 740 represents the time points (e.g., referred to as sampling points) at which the battery monitoring device or unit (e.g., 102, 202, 302, 402, or 502) synchronously samples/measures the abovementioned battery voltage VB and controllable current IB. As shown in FIG. 7, the sampling frequency F_{SP} of the battery voltage VB and controllable current IB is greater than the stimulus frequency F_{EIS} of the stimulus signal 220, e.g., the frequency of the waveform 720. In some embodiments, the sampling frequency F_{SP} of the battery voltage VB and controllable current IB can be set to different values in different EIS-data-collecting time windows. For example, the sampling frequency F_{SP} of the battery voltage VB and controllable current IB can be decreased when the stimulus frequency F_{EIS} of the stimulus signal 220 is decreased. However, the invention is not so limited. In some other embodiments, the sampling frequency F_{SP} of the battery voltage VB and controllable current IB can be set have the same frequency value in different EIS-data-collecting time windows.

Accordingly, in each time window of the EIS-data-collecting time windows 742-1 to 742-k, the battery monitoring device or unit (e.g., 102, 202, 302, 402, or 502) can generate EIS data corresponding to a frequency value (e.g., F1, F2, ..., or Fk) of the stimulus signal 220. In plot 736, each EIS dataset 738-1, 738-2, ..., or 738-k includes EIS data associated with a respective frequency value (e.g., F1, F2, ..., or Fk) of the stimulus signal 220. In some embodiments, a controller can perform EIS analysis based on the EIS datasets 738-1 to 738-k.

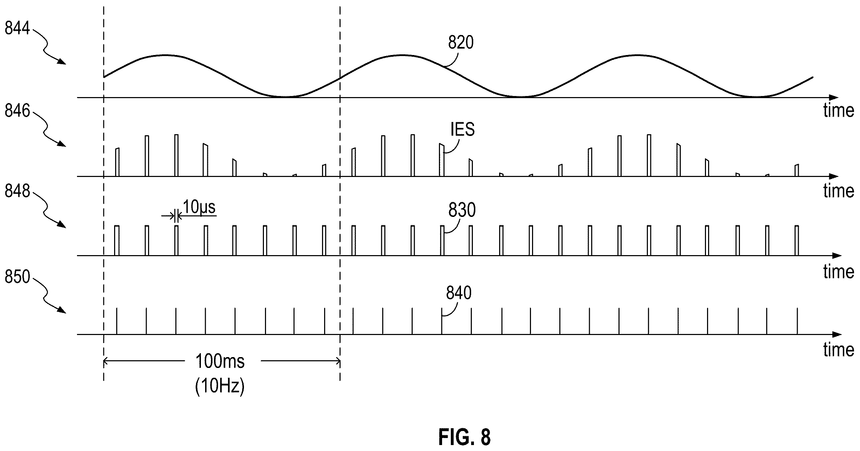

FIG. 8 illustrates a diagram of a time sequence of an example of a process of generating and controlling a stimulus current IES in an EIS-data-collecting time window, in an embodiment of the present invention. FIG. 8 is described in combination with FIG. 1, FIG. 2, FIG. 3, FIG. 4, FIG. 5, FIG. 6, and FIG. 7. The diagram in FIG. 8 includes plots 844, 846, 848, and 850. Plot 844 shows an example of a waveform 820 indicated by the abovementioned stimulus signal 220. Plot 846 shows an example of a waveform of the stimulus current IES. Plot 848 shows an example of a time sequence of a control signal 830, e.g., the same as or similar to the abovementioned control signal 230 in FIG. 2, that enables and disables the stimulus current IES. The control signal 830 may be generated by a logic control circuit (e.g., the circuit 214 in FIG. 2 to FIG. 4, or the circuit 514 in FIG. 5). Plot 850 shows an example of a time sequence of sampling points 840 (e.g., time points) of the abovementioned battery voltage VB and controllable current IB.

In an embodiment, a stimulus-current-control circuit (e.g., the circuit 210 in FIG. 2 and FIG. 3, or the circuit 410 in FIG. 4 and FIG. 5) that controls a current path (e.g., the path 104 in FIG. 1 to FIG. 4, or the path 504 in FIG. 5) to generate the stimulus current IES can be enabled or disabled by the control signal 830 at a sampling frequency F_{SP}. Thus, the current path is alternately turned on and off at the sampling frequency F_{SP}. The stimulus current IES is also generated at the sampling frequency F_{SP}. When the current path is turned on, sampling circuity (e.g., including the circuits 212, 216 and 218 in FIG. 2; the circuits 312, 216 and 218 in FIG. 3 and FIG. 4; or the circuits 512, 216 and 218 in FIG. 5) can perform the abovementioned measuring of the battery voltage VB and measuring of the controllable current IB. As a result, power consumption of the battery monitoring system can be reduced.

More specifically, in high-power battery cell/pack application in some embodiments, internal impedances of the battery cells are relatively small, e.g., down to milliohm level. Thus, the stimulus current IES applied to the battery cells (e.g., CELL1 to CELLn) may be required to be relatively large, e.g., 1A, 2A or larger. If a relatively large stimulus current IES continuously flows through the transistor M1 and current-setting resistor RSET in the current path, e.g., 102 or 502, it may result in high power consumption. Advantageously, in some embodiments of the present invention, the stimulus current IES can be alternately enabled and disabled. Thus, the power consumption can be reduced.

In the example of FIG. 8, the stimulus frequency F_{EIS} of the waveform 820 is set to be 10Hz in an EIS-data-collecting time window. In each cycle of the waveform 820, e.g., in each cycle of 100 milliseconds, the stimulus-current-control circuit can turn on the current path multiple times, e.g., eight times or more. For example, the sampling frequency F_{SP} may be set to 80Hz, 100Hz, etc. Each time, the current path can be turned on for a relatively short time, e.g., 10 microseconds, 100 microseconds, 1 millisecond, etc. The stimulus current IES is also generated for a relatively short time. As a result, the power consumption of the battery monitoring system may be significantly reduced. The stimulus current IES that is applied to the battery cells (e.g., CELL1 to CELLn) still carries the information for the waveform 820, and therefore can be used for the EIS analysis.

FIG. 9 illustrates a diagram of a time sequence of an example of a process of collecting EIS data, in another embodiment of the present invention. FIG. 9 is described in combination with FIG. 1, FIG. 2, FIG. 3, FIG. 4, FIG. 5, FIG. 6, FIG. 7, and FIG. 8. The diagram in FIG. 9 includes plots 932, 934, and 936. Similar to the plots 732, 734, and 736 in FIG. 7, plot 932 shows an example of a waveform 920 indicated by the abovementioned stimulus signal 220; plot 934 shows an example of a time sequence of sampling points 940 (e.g., time points) of the abovementioned battery voltage VB and controllable current IB; and plot 932 shows multiple EIS datasets 938-1 to 938-k (where k is a natural number) associated with respective frequency values F1 to Fk of the waveform 920. In the example of FIG. 9, the waveform 920 indicated by the stimulus signal 220 includes a square wave. The process of collecting EIS data in the example of FIG. 9 can be similar to that described in relation to FIG. 7.

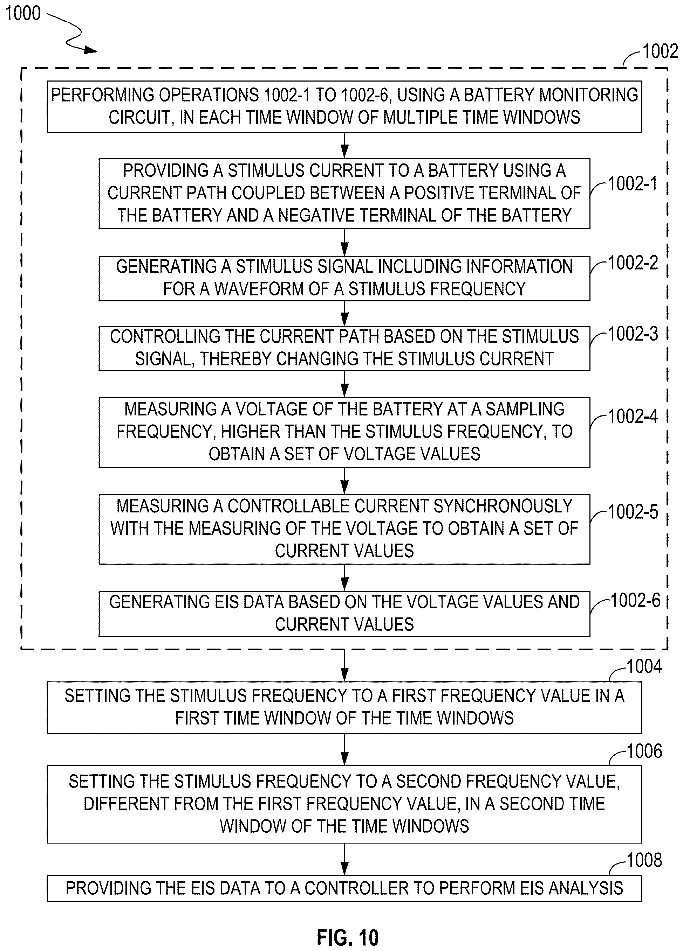

FIG. 10 illustrates a flowchart 1000 of an example of a method for monitoring, e.g., an SOH and/or SOC of, a battery, in an embodiment of the present invention. FIG. 10 is described in combination with FIG. 1, FIG. 2, FIG. 3, FIG. 4, FIG. 5, FIG. 6, FIG. 7, FIG. 8, and FIG. 9.

As shown in FIG. 10, in block 1002, a battery monitoring circuit (e.g., 102, 202, 302, 402, or 502) performs operations 1002-1 to 1002-6 in each time window of multiple EIS-data-collecting time windows (e.g., 742-1 to 742-k).

In operation 1002-1, the battery monitoring circuit provides a stimulus current IES to a battery, e.g., 108, using a current path, e.g., 104 or 504, coupled between a positive terminal, e.g., P₁₀₈, of the battery and a negative terminal, e.g., N₁₀₈, of the battery.

In operation 1002-2, stimulus circuitry in the battery monitoring circuit generates a stimulus signal, e.g., 220, including information for a waveform of a stimulus frequency F_{EIS}.

In operation 1002-3, the battery monitoring circuit controls the current path based on the stimulus signal, thereby changing the stimulus current.

In operation 1002-4, sampling circuitry in the battery monitoring circuit measures a voltage VB of the battery at a sampling frequency F_{SP}, higher than the stimulus frequency F_{EIS}, to obtain a set of voltage values.

In operation 1002-5, the sampling circuitry also measures a controllable current synchronously with the measuring of the voltage to obtain a set of current values. In an embodiment, the controllable current can be the battery's charging current or discharging current that includes the stimulus current IES. In another embodiment, the controllable current can be the stimulus current IES.

In operation 1002-6, the battery monitoring circuit generates EIS data based on the voltage values and current values.

Additionally, as shown in FIG. 10, in block 1004, the battery monitoring circuit sets the stimulus frequency F_{EIS} to a first frequency value, e.g., Fj, in a first time window, e.g., 742-j, of the multiple EIS-data-collecting time windows.

In block 1006, the battery monitoring circuit sets the stimulus frequency F_{EIS} to a second frequency value, e.g., F(j+1), different from the first frequency value, in a second time window, e.g., 742-(j+1), of the multiple EIS-data-collecting time windows.

In block 1008, the battery monitoring circuit provides the EIS data to a controller to perform EIS analysis. In some embodiments, results of the EIS analysis can used to determine the SOH and SOC of the battery.

While the foregoing description and drawings represent embodiments of the present invention, it will be understood that various additions, modifications, and substitutions may be made therein without departing from the spirit and scope of the principles of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the principles of the present invention. The presently disclosed embodiments are therefore to be considered in all respects as illustrative and not restrictive, the scope of the invention being indicated by the appended claims and their legal equivalents, and not limited to the foregoing description.

## Claims

1. A battery monitoring circuit comprising:
a current path configured to provide a stimulus current from a positive terminal of a battery through said current path to a negative terminal of said battery in a plurality of time windows comprising a first time window and a second time window;
stimulus circuitry, coupled to said current path, configured to: generate a stimulus signal comprising information for a waveform to control said current path, thereby changing said stimulus current; set a stimulus frequency of said waveform to a first frequency value in said first time window; and set said stimulus frequency to a second frequency value, different from said first frequency value, in said second time window; and
sampling circuitry, coupled to said current path and said stimulus circuitry, and configured to perform a plurality of operations in each time window of said plurality of time windows, wherein said plurality of operations comprises:
measuring a voltage of said battery at a sampling frequency, higher than said stimulus frequency, to obtain a plurality of voltage values;
measuring a controllable current synchronously with said measuring of said voltage to obtain a plurality of current values, said controllable current comprising said stimulus current; and
generating electrochemical impedance spectroscopy (EIS) data based on said plurality of voltage values and said plurality of current values,
wherein said sampling circuitry is further configured to provide said EIS data to a controller to perform an EIS analysis.

2. The battery monitoring circuit of claim 1, wherein said stimulus current reduces a charging current of said battery if said battery is in a charging mode, and wherein said stimulus current increases a discharging current of said battery if said battery is in a discharging mode.

3. The battery monitoring circuit of claim 2, wherein said measuring said controllable current comprises measuring a voltage across a sensing resistor coupled in series to said battery, and wherein said controllable current comprises a battery current selected from the group consisting of: said charging current, and said discharging current.

4. The battery monitoring circuit of claim 1 or 2, wherein said current path comprises:
a current-setting resistor; and
a transistor coupled to said current-setting resistor and controlled by said stimulus signal.

5. The battery monitoring circuit of claim 4, wherein said measuring said controllable current comprises measuring a voltage across said current-setting resistor, and wherein said controllable current is said stimulus current.

6. The battery monitoring circuit of claim 4, wherein said battery monitoring circuit is configured to operate in a mode of a regular mode and a stimulus mode, wherein said current path is off in said regular mode, and wherein said battery monitoring circuit enters a time window of said plurality of time windows in said stimulus mode; and
wherein said sampling circuitry comprises an analog-to-digital converter (ADC) having an input range controlled by a reference voltage; wherein in said regular mode, said reference voltage is set to a first value, and said ADC measures a battery current of said battery by measuring a voltage across a sensing resistor coupled in series to said battery; and wherein in said stimulus mode, said reference voltage is set to a second value greater than said first value, and said ADC measures said stimulus current by measuring a voltage across said current-setting resistor.

7. The battery monitoring circuit of claim 4, wherein said stimulus circuitry comprises an operational amplifier comprising:
a first input terminal configured to receive a preset voltage determined by said stimulus signal;
an output terminal configured to control said transistor; and
a second input terminal configured to apply said preset voltage to said current-setting resistor, thereby setting said stimulus current.

8. The battery monitoring circuit of any of claims 1 to 7, wherein in said each time window, said stimulus circuitry is configured to alternately turn on and off said current path at said sampling frequency, and wherein said sampling circuitry performs said measuring said voltage and said measuring said controllable current when said current path is turned on.

9. The battery monitoring circuit of any of claims 1 to 8, wherein said battery comprises a plurality of cells, and wherein said voltage of said battery comprises a voltage selected from the group consisting of: respective cell voltages of said plurality of cells, and a battery voltage across said battery.

10. A battery monitoring device comprising:
a monitoring terminal configured to monitor a voltage of a battery;
a control terminal configured to control a current path coupled between a positive terminal of said battery and a negative terminal of said battery; and
stimulus-and-sampling circuitry, coupled to said monitoring terminal and said control terminal, and configured to perform a plurality of operations in each time window of a plurality of time windows, wherein said plurality of operations comprises:
generating a stimulus signal comprising information for a waveform of a stimulus frequency;
controlling, through said control terminal, said current path based on said stimulus signal, thereby changing a stimulus current that flows through said current path;
measuring said voltage of said battery at a sampling frequency, higher than said stimulus frequency, to obtain a plurality of voltage values;
measuring a controllable current synchronously with said measuring of said voltage to obtain a plurality of current values, said controllable current comprising said stimulus current; and
generating electrochemical impedance spectroscopy (EIS) data based on said plurality of voltage values and said plurality of current values,
wherein said stimulus-and-sampling circuitry is further configured to: set said stimulus frequency to a first frequency value in a first time window of said plurality of time windows; set said stimulus frequency to a second frequency value, different from said first frequency value, in a second time window of said plurality of time windows; and provide said EIS data to a controller to perform an EIS analysis.

11. The battery monitoring device of claim 10, wherein said stimulus-and-sampling circuitry is configured to control a transistor in said current path, thereby controlling said stimulus current to flow through a current-setting resistor in said current path.

12. The battery monitoring device of claim 11, wherein said measuring said controllable current comprises measuring a voltage across said current-setting resistor, and wherein said controllable current is said stimulus current.

13. The battery monitoring device of claim 11, wherein said stimulus-and-sampling circuitry is configured to operate in a mode of a regular mode and a stimulus mode, wherein said current path is off in said regular mode, and wherein said stimulus-and-sampling circuitry enters a time window of said plurality of time windows in said stimulus mode; and
wherein said stimulus-and-sampling circuitry comprises an analog-to-digital converter (ADC) having an input range controlled by a reference voltage; wherein in said regular mode, said reference voltage is set to a first value, and said ADC measures a battery current of said battery by measuring a voltage across a sensing resistor coupled in series to said battery; and wherein in said stimulus mode, said reference voltage is set to a second value greater than said first value, and said ADC measures said stimulus current by measuring a voltage across said current-setting resistor.

14. The battery monitoring device of claim 11, wherein said stimulus-and-sampling circuitry comprises an operational amplifier comprising:
a first input terminal configured to receive a preset voltage determined by said stimulus signal;
an output terminal configured to control said transistor; and
a second input terminal configured to apply said preset voltage to said current-setting resistor thereby setting said stimulus current.

15. The battery monitoring device of any of claims 10 to 14, wherein in said each time window, said stimulus-and-sampling circuitry is further configured to alternately turn on and off said current path at said sampling frequency, and wherein said stimulus-and-sampling circuitry performs said measuring said voltage and said measuring said controllable current when said current path is turned on.
